# EUROPEAN PATENT APPLICATION

(11) **EP 4 776 031 A1**
(43) Date of publication of application: **15.07.2026**
(21) Application number: 24862793.7
(22) Date of filing: 03.09.2024
(51) Int. Cl.: G01T 1/24, C30B 11/00, C30B 13/00, C30B 29/12

(54) **RADIATION DETECTOR AND METHOD FOR MANUFACTURING SAME**

(30) Priority: 04.09.2023 JP 2023143087
(71) Applicant: National University Corporation Hokkaido University, Hokkaido 060-0808 (JP)
(72) Inventor: KANEKO, Junichi, Sapporo-shi, Hokkaido 060-0808 (JP); YAMAISHI, Naoya, Sapporo-shi, Hokkaido 060-0808 (JP); HIGUCHI, Mikio, Sapporo-shi, Hokkaido 060-0808 (JP)
(74) Representative: J A Kemp LLP
(86) International application number: PCT/JP2024/031610
(87) International publication number: WO 2025/053141

(57) **Abstract**

Good electrical contact can be easily ensured while an electrode made of a metal different from thallium is used. A radiation detector 1 includes a crystal 2 whose main component is thallium bromide and electrodes 3 and 4 which are in contact with the crystal 2 to sandwich the crystal 2 in an X direction and are made of a metal different from thallium. At least one of strontium, lead, thallium, and bromine is doped in a portion where the crystal 2 is in contact with each of the electrodes 3 and 4.

## Description

### [Technical Field]

The present teaching relates to a radiation detector and a method for manufacturing the same.

### [Background Art]

For radiation detectors used for environmental monitoring and medical applications, research has been done to use a crystal with thallium bromide as a main material, from the perspectives of, for example, detection efficiency and cost reduction. Patent Literature 1 shows an example of a radiation detector using such a crystal, which employs a structure in which a thallium bromide crystal is sandwiched by paired thallium electrodes.

### [Citation List]

### [Patent Literatures]

[Patent Literature 1] Japanese Patent No. 5083964

### [Summary of Invention]

### [Technical Problem]

Thallium corrodes easily when oxidized. Due to this, when the electrodes are made of thallium, the characteristics of the detector tend to deteriorate. However, when the electrodes are made of a metal different from thallium, the properties of radiation detection depend on whether good electric contact is achieved between the electrodes and the crystal.

An object of the present invention is to provide a radiation detector by which good electric contact is easily ensured while using an electrode made of a metal different from thallium, and a method of manufacturing the radiation detector.

### [Solution to Problem]

A radiation detector according to the present teaching includes: a crystal whose main component is thallium bromide; and a first electrode and a second electrode which are in contact with the crystal to sandwich the crystal in one direction and are made of a metal different from thallium, the crystal being doped with at least one of strontium, lead, thallium, and bromine at a portion where the crystal is in contact with at least one of the first electrode or the second electrode.

According to the present teaching, a metal other than thallium is used as the electrodes in the radiation detector. As a result, there is no decrease in detection performance due to the corrosion of thallium. In addition, at least one of strontium, lead, thallium, and bromine is doped in portions where the crystal is in contact with the electrodes. This makes it easy to ensure proper ohmic contact. It is therefore possible to realize a radiation detector that easily ensures good electrical contact while using a metal other than thallium for the electrodes.

The present teaching may be arranged such that the crystal is doped with at least one of strontium, lead, thallium, and bromine both at a portion where the crystal is in contact with the first electrode and a portion where the crystal is in contact with the second electrode. This makes it easy to properly secure ohmic contact at both the first electrode and the second electrode.

The present teaching is preferably arranged such that at least one of the first electrode or the second electrode is made of gold. According to this arrangement, the electrical conductivity between the electrodes and the crystal is more easily secured.

The present teaching is preferably arranged such that the other of the first electrode and the second electrode is made of gold, platinum, aluminum, indium, or chromium. According to this arrangement, ohmic contact is likely to be ensured between the electrodes and the crystal.

A method for manufacturing a radiation detector according to another aspect of the present teaching is a method for manufacturing a radiation detector including a crystal whose main component is thallium bromide and a first electrode and a second electrode which are in contact with the crystal to sandwich the crystal in one direction, the method including the steps of: partially doping the crystal with an element with which the crystal and at least one of the first electrode or the second electrode are in ohmic contact; and providing at least one of the first electrode or the second electrode made of a metal different from thallium so as to make contact with a portion where the crystal is doped with the element.

According to the method for manufacturing the radiation detector of the present teaching, a metal other than thallium is used as the electrodes in the radiation detector. As a result, there is no decrease in detection performance due to the corrosion of thallium. Furthermore, the crystal is doped with an element with which the crystal and the electrodes are in ohmic contact at portions where the crystal is in contact with the electrodes. It is therefore possible to realize a radiation detector that easily ensures good electrical contact while using a metal other than thallium for the electrode.

### [Brief Description of Drawings]

FIG. 1 is a conceptual diagram of the structure of a radiation detector of an embodiment of the present teaching.
FIG. 2 is a plan view of a sample used in an experiment for checking the characteristics of electric contact between a crystal and electrodes in the radiation detector of FIG. 1.
FIG. 3 is a graph showing experimentation results of current-voltage characteristics when strontium is used as a dopant and various metals are used as the electrodes in the sample of FIG. 2.
FIG. 4 is a graph showing experimentation results of current-voltage characteristics when lead is used as a dopant and various metals are used as the electrodes in the sample of FIG. 2.
FIG. 5 is a graph showing experimentation results of current-voltage characteristics on a surface of a substrate when various substances are used as a dopant in the substrate used in the sample of FIG. 2.

### [Description of Embodiments]

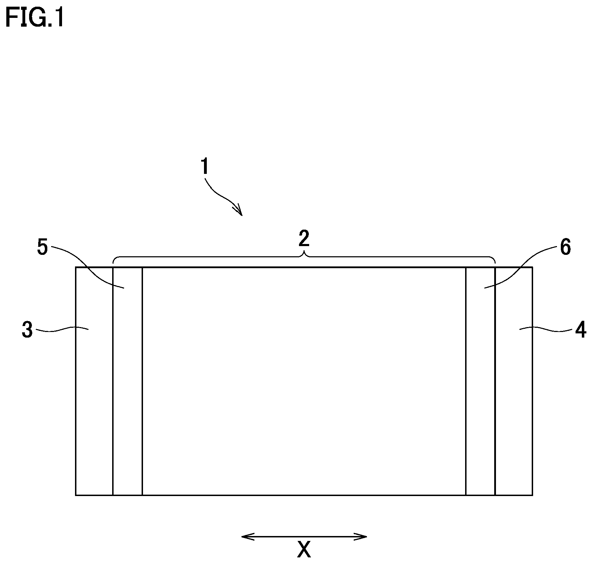

The following will describe a radiation detector 1 of an embodiment of the present teaching with reference to FIG. 1. The radiation detector 1 includes a crystal 2 and electrodes 3 and 4. Main components of the crystal 2 are bromine and thallium. A main component refers to a component that exists in a composition ratio of 0.3 or more in the crystal. In other words, if the total number of atoms of bromine and thallium is X and the number of all atoms is Y, then X/Y is 0.3 or more. Due to this, bromine and thallium in the crystal 2 function as the main components for radiation detection ("Realization of Cherenkov PET with photon-electron hybrid detectors using transparent semiconductors" (Keitaro HITOMI et al., 2019-2020, https://kaken.nii.ac.jp/ja/grant/KAKENHI-PROJECT-19K22942/)).

The crystal 2 may include elements different from the main components in its entirety. Apart from those inevitably included in the thallium bromide crystal at the time of growth of the crystal, the elements different from the main components include elements that are different from bromine and thallium and exist in the crystal as a result of doping performed for the thallium bromide crystal in order to, for example, compensating defects in the crystal. The inevitable impurities remaining in the crystal form donor or acceptor levels within the band gap and consequently increase leakage current, that is, sources of noise. Doping to compensate defects refers to introducing dopants that act as acceptors or donors so as to compensate the levels. Another specific example of the doping is chlorine doping mentioned in the above-described "Realization of Cherenkov PET with photon-electron hybrid detectors using transparent semiconductors". This is done to achieve the following: the crystal is transparentized by increasing the band gap of the crystal, Cherenkov light radiated by interaction between the crystal 2 and gamma rays is allowed to pass through the crystal 2, and the Cherenkov light is measured by an external light detector.

The electrodes 3 and 4 are formed on the surface of the crystal 2 to be in contact with the crystal 2. The electrodes 3 and 4 sandwich the crystal 2 in an X direction. Either the electrode 3 or the electrode 4 is used as the cathode, while the other is used as the anode. One of the electrodes 3 and 4 is made of gold, whereas the other is made of gold, platinum, aluminum, indium, or chromium. The electrodes may be made of an alloy of these metals. The electrodes 3 and 4 are formed on the crystal 2 by using vapor deposition or sputtering. A specific method of vapor deposition or sputtering (sputter) is selected from RF sputtering, DC sputtering, resistance heating vapor deposition, and electron-beam vapor deposition, depending on the type of metal. The electrodes 3 and 4 may be variously structured. For example, each electrode may be composed of a single electrode or plural electrodes. The shape of each electrode may be rectangular, circular, or oval. When there are plural electrodes, the electrodes may be formed on the surface of the crystal 2 in a lattice manner.

Portions of the crystal 2, which include parts where the electrodes 3 and 4 are formed on the surface, are doping layers 5 and 6 doped by a thermal diffusion method. The element with which the doping layers 5 and 6 are doped is at least one of strontium, lead, thallium, and bromine. Other candidates of the doping element are magnesium, calcium, zinc, germanium, indium, gallium, cobalt, tellurium, and selenium.

The following describes a method of using the radiation detector 1. When a voltage is applied between the electrodes 3 and 4, electron-hole pairs generated by radiation incident on the crystal 2 move due to the applied voltage. In this way, the radiation incident on the crystal 2 is detected as a current generated between the electrodes is detected by an appropriate detector.

### (Experimental Examples)

### (Experimental Example 1)

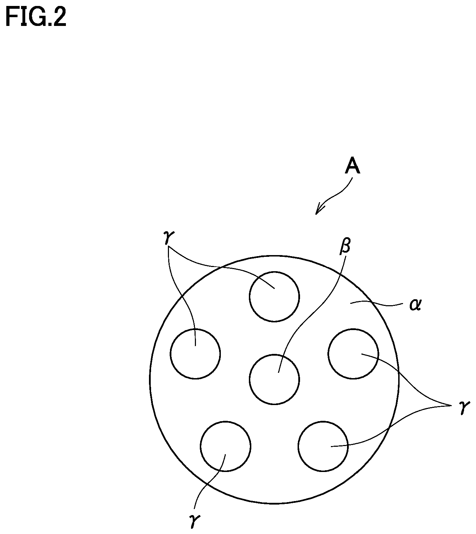

As shown in FIG. 2, a sample A of this experimental example is a simulation of a contact structure of the crystal 2 and the electrode 3 or 4 in the radiation detector 1, and includes a substrate α, one electrode β, and five electrodes γ. The substrate α is a disk-shaped single crystal made of thallium bromide. The substrate α is doped with strontium or lead from its circular surface α1. The doped area does not reach the surface on the opposite side of the surface α1 and has a predetermined depth from the surface α1 in a thickness direction orthogonal to the surface α1. The electrode β and the electrodes γ are formed on the surface α1. The electrode β is made of gold and is positioned substantially at the center of the surface α1. The five electrodes γ are made of gold, platinum, aluminum, indium, and chromium, respectively. These electrodes γ are provided around the electrode β so as to surround the electrode β.

In the present experimental example, the sample A was prepared in the following manner. Using thallium bromide powder with 4N purity, a thallium bromide crystal with a diameter of 12 mm was obtained through purification and single crystal growth based on a vertical Bridgman method and a zone melting method. The crystal was then cut into a wafer approximately 1 mm thick. On this wafer-shaped thallium bromide crystal, a disc-shaped pellet made of bromide that was a dopant was placed, and they were heated in an atmosphere composed mainly of argon and hydrogen. To be more specific, the temperature was changed from the room temperature to the highest temperature exceeding the melting point of the above-described bromide. Subsequently, after maintaining the crystal with the pellet at the highest temperature for a predetermined time, the crystal was slowly cooled over more than 10 hours. This was done for strontium bromide and for lead bromide as the bromide mentioned above. As a result, two types of the substrates α doped with strontium and lead, respectively, were obtained.

Subsequently, by sputtering or vapor deposition of gold, platinum, aluminum, indium, and chromium, the electrodes β and γ were formed on the surface α1 of each of the two types of the substrates α. Resistance heating vapor deposition was used for gold, aluminum, and indium, DC sputtering was used for platinum, and RF sputtering was used for chromium. As a result, two types of samples A doped with strontium and lead, respectively, were obtained.

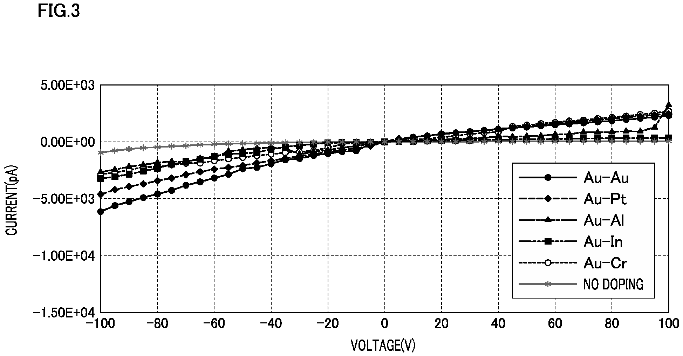

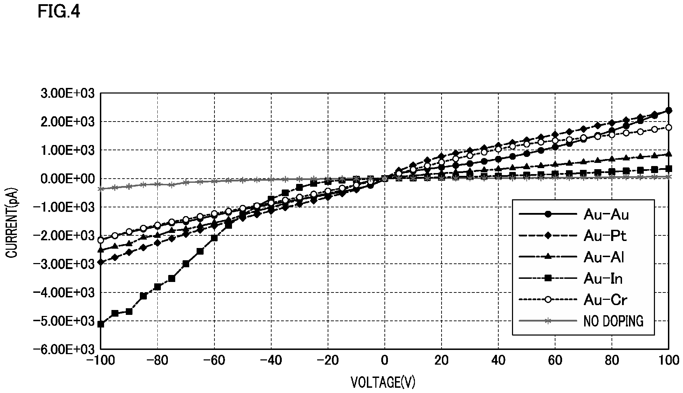

Subsequently, regarding the two types of samples A described above, the current-voltage characteristics between the electrode β and each electrode γ were evaluated using a measurement device (B1505A Power Device Analyzer made by Keysight Technologies). As a control, the current-voltage characteristics between two points on the surface of the thallium bromide crystal without any doping of elements were also evaluated. The results are shown in FIG. 3 and FIG. 4. FIG. 3 relates to the sample A doped with strontium, whereas FIG. 4 relates to the sample A doped with lead. In both FIG. 3 and FIG. 4, "Au-X" (X is one of Au, Pt, Al, In, and Cr) corresponds to the current-voltage characteristics between the electrode β and the electrode γ made of X. "No Doping" is equivalent to the control current-voltage characteristics.

As shown in FIG. 3 and FIG. 4, the characteristics in which the voltage is almost proportional to the electric current between the electrode β and each electrode γ were obtained for each of the two types of samples A. In other words, it was demonstrated that ohmic contact is ensured between the electrode β or γ and the crystal. It was found that, when gold is used for one of the two electrodes and a material selected from gold, platinum, aluminum, indium, and chromium is used for the other electrode, ohmic contact is properly ensured. Furthermore, it was found that using gold as the electrode is preferable in terms of improving electrical conductivity.

### (Experimental Example 2)

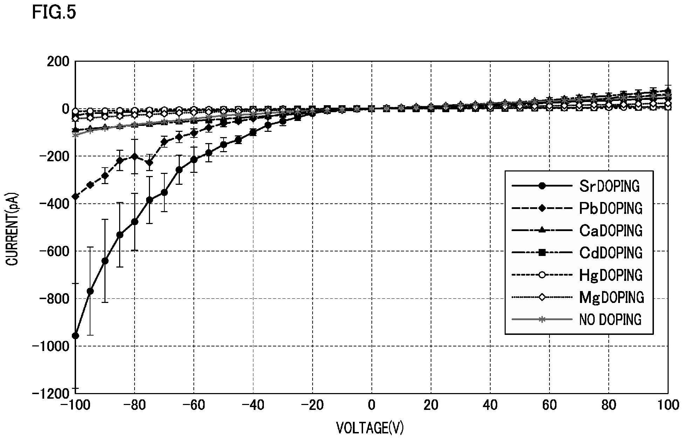

Six types of substrates α doped with strontium, lead, calcium, cadmium, mercury, and magnesium were produced using the same method as in Experimental Example 1. By directly applying a measurement probe of the measurement device in Experimental Example 1 to two points on the doped surface of each substrate α, the current-voltage characteristics between these two points were evaluated. As a control, the current-voltage characteristics between two points on the surface of the thallium bromide crystal without any doping of elements were also evaluated. The results are shown in FIG. 5. As shown in FIG. 5, the current-voltage characteristics of the substrate α doped with calcium, cadmium, mercury, or magnesium were not different from the control current-voltage characteristics. In contrast, the current-voltage characteristics of the substrate α doped with strontium or lead exhibited significant differences from the control current-voltage characteristics. In addition, a similar evaluation was carried out for a sulfur-doped substrate α. No differences were observed between its current-voltage characteristics and those of the control.

### (Experimental Example 3)

For the substrate α produced in the experimental example 1, the distribution of each type of atoms in the substrate α was measured using secondary ion mass spectrometry (SIMS) with a quadrupole mass spectrometer (PHIADEPT-1010 made by ULVAC-PHI, Inc.). As a result, it was found that strontium is distributed in the strontium-doped substrate α up to a depth of about 10 µm from the surface. It was also found that lead is distributed in the lead-doped substrate α up to a depth of about 3 to 5 µm from the surface.

### [Effects of Present Embodiment]

According to the present embodiment described above, a metal other than thallium is used as the electrodes 3 and 4 in the radiation detector 1. As a result, there is no decrease in detection performance due to the corrosion of thallium. In addition, at least one of strontium, lead, thallium, and bromine is doped in a portion where the crystal 2 is in contact with each of the electrodes 3 and 4. As a result, in each of the electrodes 3 and 4, ohmic contact can be appropriately ensured as shown in the above-described experimental example regarding the doping of strontium and lead. Furthermore, ohmic contact can be appropriately ensured regarding the doping of at least one of thallium and bromine. This is because, by changing the composition ratio of thallium and bromine in the crystal 2 from 1:1 through doping of at least one of thallium or bromine, the doping layer 5 or 6 can be made to be in an electron-rich state or a hole-rich state. It is therefore possible to realize a detector that easily ensures good electrical contact while using a metal other than thallium for the electrode. This is applicable to the crystals 2 doped with magnesium, calcium, zinc, germanium, indium, gallium, cobalt, tellurium, and selenium.

### <Modifications>

A preferred embodiment of the present teaching has been described above. It should be noted that the present teaching is not limited to the above-mentioned embodiment and various changes, substitutions, and alterations can be made herein without departing from the spirit and scope of the teaching as described in the solution to problem.

For example, in the embodiment above, the doping layers 5 and 6 doped with strontium, etc. are formed on the respective surfaces of the crystal 2 where the electrodes 3 and 4 are formed. Alternatively, a doping layer doped with strontium, etc. may be formed only on the surface where one of the electrodes 3 and 4 is formed.

In the embodiment above, ohmic contact is ensured between both of the electrodes 3 and 4 and the crystal 2. In this regard, ohmic contact may be ensured between at least one of the electrode 3 or 4 and the crystal 2. To put it differently, one of the electrodes 3 and 4 may be in ohmic contact whereas the other is in ohmic contact or Schottky contact.

In the embodiment above, the electrodes 3 and 4 are made of gold, platinum, aluminum, indium, or chromium. In this regard, at least one of the electrode 3 or 4 may be made of metal oxide semiconductor such as indium tin oxide and tin dioxide. These materials are oxides and are therefore unlikely to be influenced by oxidation by bromine, and the doping layer 5 or 6 made of strontium, etc. exists at around the interface between the electrodes 3 and 4 and the crystal 2. For these reasons, the electrodes are likely to be stable.

### [Reference Signs List]

1 radiation detector
2 crystal
3, 4 electrode
5, 6 doping layer

## Claims

1. A radiation detector comprising:
a crystal whose main component is thallium bromide; and
a first electrode and a second electrode which are in contact with the crystal to sandwich the crystal in one direction and are made of a metal different from thallium,
the crystal being doped with at least one of strontium, lead, thallium, and bromine at a portion where the crystal is in contact with at least one of the first electrode or the second electrode.

2. The radiation detector according to claim 1, wherein, the crystal is doped with at least one of strontium, lead, thallium, and bromine both at a portion where the crystal is in contact with the first electrode and a portion where the crystal is in contact with the second electrode.

3. The radiation detector according to claim 1 or 2, wherein, at least one of the first electrode or the second electrode is made of gold.

4. The radiation detector according to claim 3, wherein, the other of the first electrode and the second electrode is made of gold, platinum, aluminum, indium, or chromium.

5. A method for manufacturing a radiation detector including a crystal whose main component is thallium bromide and a first electrode and a second electrode which are in contact with the crystal to sandwich the crystal in one direction,
the method comprising the steps of: partially doping the crystal with an element with which the crystal and at least one of the first electrode or the second electrode are in ohmic contact; and providing at least one of the first electrode or the second electrode made of a metal different from thallium so as to make contact with a portion where the crystal is doped with the element.
